(19) **Europäisches Patentamt European Patent Office Office européen des brevets**

(11) **EP 3 799 231 B1**

(12) **EUROPEAN PATENT SPECIFICATION**

(45) Date of publication and mention
of the grant of the patent:
**21.02.2024 Bulletin 2024/08**

(21) Application number: **19200195.6**

(22) Date of filing: **27.09.2019**

(51) International Patent Classification (IPC):
*H01S 5/14* (2006.01)  *G01L 11/02* (2006.01)
*G01B 9/02* (2022.01)  *G01D 5/26* (2006.01)
*G02B 6/12* (2006.01)  *G02B 6/293* (2006.01)
*H04R 23/00* (2006.01)

(52) Cooperative Patent Classification (CPC):
**H01S 5/141; G01L 11/02; H04R 23/008;**
G01B 9/02051; G01B 2290/30; G02B 6/2935;
G02B 2006/12107; G02B 2006/12121;
G02B 2006/12159

(54) **OPTICAL DEVICE, PHOTONIC DETECTOR, AND METHOD OF MANUFACTURING AN OPTICAL DEVICE**

OPTISCHE VORRICHTUNG, PHOTONISCHER DETEKTOR UND VERFAHREN ZUR HERSTELLUNG EINER OPTISCHEN VORRICHTUNG

DISPOSITIF OPTIQUE, DÉTECTEUR PHOTONIQUE ET PROCÉDÉ DE FABRICATION D'UN DISPOSITIF OPTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.03.2021 Bulletin 2021/13**

(73) Proprietor: **ams International AG 8645 Jona (CH)**

(72) Inventors:
• **Lazar, Catalin**
  **8640 Rapperswil (CH)**
• **Stojanovic, Goran**
  **8640 Rapperswil (CH)**
• **Steele, Colin**
  **8640 Rapperswil (CH)**

(74) Representative: **Epping - Hermann - Fischer Patentanwaltsgesellschaft mbH Schloßschmidstraße 5 80639 München (DE)**

(56) References cited:
**US-A1- 2004 258 109    US-B1- 7 355 720**

• **DEGERTEKIN F L ET AL: "Fabrication and Characterization of a Micromachined Acoustic Sensor With Integrated Optical Readout", IEEE JOURNAL OF SELECTED TOPICS IN QUANTUM ELECTRONICS, IEEE SERVICE CENTER, PISCATAWAY, NJ, US, vol. 10, no. 3, 1 May 2004 (2004-05-01), pages 643-651, XP011116315, ISSN: 1077-260X, DOI: 10.1109/JSTQE.2004.829198**

**Description**

The following relates to the field of optical sensors, including an optical device, a photonic detector and a method of manufacturing an optical device.

Optical sensors are often equipped with their own light source integrated into the same sensor package. Examples include time-of-flight sensors, spectral sensors and proximity sensors, etc. Semiconductor lasers, such as Vertical-cavity surface-emitting lasers, VCSELs, or Fabry-Perot edge-emitting semiconductor lasers, are possible light sources as they can be fabricated at wafer-level alongside other components of the optical sensor, which may then be integrated into the same sensor package, thus providing highly integrated and dedicated sensor solutions.

External cavities can be used to improve semiconductor laser performances, especially when they are complemented with a diffraction grating or similar, such as a Bragg grating, for instance. An external cavity may also improve mode stability, hence phase stability of the laser, and reduces the laser spectral linewidth and noise. A diffraction grating as part of an external cavity improves frequency stability and tuning range. Multi-mode laser diodes may become single-mode with the help of an external grating. Examples include DFB and DBR semiconductor lasers which, despite the long cavity, are typically single-mode. As a side-effect, external cavities may improve laser conversion efficiency. Some of the characteristics mentioned above, like single-mode operation, mode- and frequency-stability, low linewidth and noise, may prove essential when the semiconductor laser is used with an interferometer.

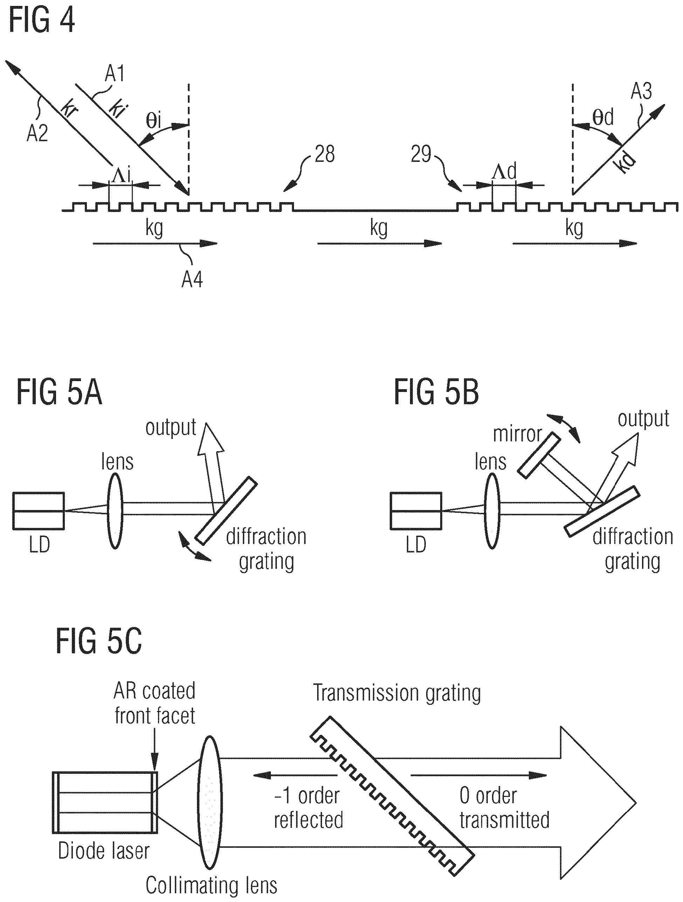

An external cavity can be complemented with a diffraction grating, such as a Bragg grating. The diffraction grating may have a number of orders of diffraction, as determined by its grating equation. For example, if one diffraction order is arranged to direct incident waves from the laser process back into the laser cavity the grating may act as a wavelength selective feedback element for the semiconductor laser. The grating may essentially replace the laser's front- or back-mirror, for example. Another diffraction order of the diffraction grating can be directed outside the laser cavity and aimed at a laser target, for example. There are various setups of placing a diffraction grating to make an external cavity to a laser, such as Littrow (Figure 5a), Littman-Metcalf (Figure 5b) or a transmission configuration (Figure 5c), for example.

A number of integrated optical sensors systems work on the principle of an interferometer. Such optical sensors may be composed of a semiconductor laser source and a sensing element. The sensing element transduces a physical measure (such as pressure, temperature, etc.) into an optical path change, e.g. which is sensed by interference with a reference path. The optical sensor may have one or several diffractive elements, such as Bragg gratings. These gratings may work as couplers at the input, output or inside the core of the sensor.

The diffractive gratings are wavelength-selective and a mismatch between the laser wavelength and the grating periods may degrade the system performances.

In order for an interferometer to have good sensitivity, however, the laser source should be single-mode which supports stable wavelength and small noise and linewidth. The Fabry-Perot edge-emitting semiconductor lasers are multi-mode longitudinally. Special measures are often needed to obtain a single-mode single-wavelength source. Usually such lasers are replaced by distributed feedback lasers, DFB, or distributed Bragg reflector lasers, DBR. VCSEL semiconductor lasers may be single-mode longitudinally by design but can be multimode transversally. Semiconductor lasers are often temperature-dependent, i.e. their laser wavelength increases with increasing temperature.

Wavelength matching between laser and sensing element is often supported by good wavelength accuracy of the laser diode and the sensing element separately. DFB or DBR laser are often used instead of a Fabry-Perot laser. These laser diodes integrate a Bragg grating at the end of their laser cavity, respectively, thus operating mostly single-mode. Nevertheless at manufacturing some laser diodes may turn out to be dual-mode longitudinally, e.g. in the case of DFB lasers. Therefore, they are sorted during production, which further increases their price. An even more accurate and stable wavelength is obtained from a laser diode with the help of an external cavity made of one or more diffractive gratings. Nevertheless, this is a bulky solution and more appropriate for a lab environment than for mass-production. To ensure stability with temperature, laser diode modules are typically thermo-compensated, using a Peltier cell or similar. All the above solutions are expensive or bulky.

Consider an optical sensor system which is composed of a semiconductor laser source and an optical sensing device, the latter including one or more diffractive optics devices, such as diffraction gratings, Bragg gratings, or similar. Such devices may require a good matching between the laser wavelength and the diffractive elements, in order to have optimal performances. The semiconductor laser may show a spread of the wavelength (device-to-device), may be multimode, i.e. having several emission wavelengths simultaneously or change its wavelength over temperature. If a semiconductor laser is used as the light source in an optical sensor system including a grating, and if the relationship between the grating period and the wavelength is critical, which often is the case in many practical applications, any of the abovementioned effects may result in a mismatch between the laser wavelength and the grating period, thus impairing the system (laser + optical sensor) performance. For instance, let's assume that a laser beam is coupled out from a waveguide by a Bragg grating towards a specific direction. If the laser wavelength changes, or if the grating period changes, or if both change but at different rates, the diffracted beam changes its direction. This may have impact on the system performance.

US 2004/0258109 A1 shows a solid laser apparatus with a wavelength converter temperature controller 40 arranged for driving a Peltier device 41 to control the temperature Tc of a wavelength converter 5 so that the acceptable wavelength range of the wavelength converter 5 adapts to the wavelength range of reflected light from the grating part 6 at the temperature Ti and a laser controller 60 arranged for driving a semiconductor light amplifier device 1 to maintain the intensity of the extraordinary component passed through the polarizer 52 and measured by a photometer device 57.

US 7,355,720 B1 shows an optical displacement sensor which uses a vertical-cavity surface-emitting laser (VCSEL) coupled to an optical cavity formed by a moveable membrane and an output mirror of the VCSEL. This arrangement renders the lasing characteristics of the VCSEL sensitive to any movement of the membrane produced by sound, vibrations, pressure changes, acceleration, etc. Some embodiments of the optical displacement sensor can further include a light-reflective diffractive lens located on the membrane or adjacent to the VCSEL to control the amount of lasing light coupled back into the VCSEL. A photodetector detects a portion of the lasing light from the VCSEL to provide an electrical output signal for the optical displacement sensor which varies with the movement of the membrane.

Furthermore, Degertekin, F. L. et al. show "Fabrication and Characterization of a Micromachined Acoustic Sensor With Integrated Optical Readout" in IEEE Journal of Selected Topics in Quantum Electronics (Volume: 10, Issue: 3, May-June 2004) .

It is an objective to provide an optical device, a method of manufacturing an optical device and a photonic detector with improved laser properties.

These objectives are achieved by the subject matter of the independent claims. Further developments and embodiments are described in dependent claims.

It is to be understood that any feature described in relation to any one embodiment may be used alone, or in combination with other features described herein, and may also be used in combination with one or more features of any other of the embodiments, or any combination of any other of the embodiments unless described as an alternative.

The following relates to an improved concept in the field of optical sensors. The improved concept suggests means to improve laser properties for integrated optical sensors. For example, an optical device for an optical sensor comprises a gain element of a semiconductor laser, a wavelength selective feedback element and a sensing element. The wavelength selective feedback element, e.g. a diffractive grating, is suggested to make common body with the sensing element. This way the wavelength selective feedback element may be part of an external cavity for the semiconductor laser.

In at least one embodiment an optical device for an optical sensor comprises a gain element of a semiconductor laser, a wavelength selective feedback element and a sensing element. At least part of the wavelength selective feedback element and the sensing element are arranged in a common sensor package. The gain element and the wavelength selective feedback element form at least part of an external cavity of the semiconductor laser.

The gain element is arranged to generate and amplify an optical signal. For example, the gain element comprises an active laser medium (also called gain medium or lasing medium) from a semiconductor material which can be considered the source of optical gain within the semiconductor laser. The gain element and the wavelength selective element provide a feedback mechanism to sustain laser oscillation depending on the optical signal. The gain results from stimulated emission in the gain element, e.g. the active laser medium is excited by a pump source. The optical signal is generated by the laser oscillation and constitutes electromagnetic radiation of a given wavelength. The wavelength of the optical signal may be in the infrared, IR, visible, Vis, or ultra violet, UV, spectrum. The wavelength selective feedback element is arranged to couple out a fraction of the optical signal. Said fraction of the optical signal is directed towards the sensing element to probe a physical property of the sensing element. Said fraction of the optical signal can be considered laser light which is used to probe the sensing element.

The optical device allows the semiconductor laser to tune itself to an optimal wavelength for the sensing element (or target), e.g. for the sensor grating period, even in real time. This allows the laser to track the target in wavelength and keep the optical device at an optimal operation point. In contrast, current systems would require accurate adjustment of laser wavelength when starting to operate, then keeping the environmental conditions for the optical device as stable as possible, because both grating and sensing element may vary differently (with temperature, for example). Instead of adjusting the laser wavelength independently from the target, the semiconductor laser may adjust itself to the wavelength defined by the target, i.e. the sensing element. This is possible because the external cavity, at least in part, forms common body with the laser target instead of being attached to the laser, as it is the case in the common external cavity lasers. The improved concept is supported by the type of application, e.g. integration of the sensor with the laser. There is no fixed reference wavelength for all components of the optical device. Instead, the target is largely free to vary its properties thus being the "master" of the laser wavelength. The laser can be considered a "slave" as it tracks the frequency imposed by the "master". The tracking by the laser of the wavelength selective feedback element takes place continuously, e.g. in real time. This reduces the constraints of keeping the laser and sensor element at constant environmental conditions to ensure wavelength stability and avoid thermal expansion, for instance.

In at least one embodiment the gain element and the external cavity are arranged in the common sensor package. This way the at least the wavelength selective feedback element, the sensing element, the gain element and the external cavity are all arranged in the common sensor package. On one side this allows for a compact design of the optical device. The optical device may be complemented with additional components in order to create a photonic detector in the common sensor package. On the other side, arranging said components all in the same sensor package further improves laser properties. In a certain sense the at least one wavelength selective feedback element, the sensing element, the gain element and the external cavity are mechanically, optically and thermally coupled by means of the common sensor package. Due to the coupling said components of the optical device are all similarly affected by the environmental conditions. The semiconductor laser wavelength tracks the period of the wavelength selective feedback element, thus counteracting the effects of thermal expansion on the light path stability, for instance. In general, the gain element or laser can be outside the common sensor package, provided the wavelength selective feedback element is part of the common sensor package.

The common sensor package is arranged to align the components of the optical device. For example, the common sensor package comprises a frame body, such as a mold structure, which confines the optical device. For example, the frame body may have side-walls and/or a cover section to which at least the wavelength selective feedback element and the sensing element are attached to.

Another example of common sensor package is a single piece of semiconductor such as silicon, into which at least both the wavelength selective feedback element and the sensing element are embedded, e.g. through semiconductor device manufacturing procedures like photolithography, etching, implantation, diffusion, oxidation, etc.. For instance, the wavelength selective element can be a (Bragg) grating etched into an optical waveguide made of, for instance, a dielectric (e.g. silicon dioxide, silicon nitride) at the surface of the semiconductor, while the sensing element can be a combination of the same grating and a MEMS membrane etched into the same piece of semiconductor. The common semiconductor substrate shared by both elements ensures a same thermal/mechanical expansion for both of them.

In at least one embodiment the wavelength selective feedback element comprises at least one diffractive input grating with a grating period $\Lambda$. The external cavity is arranged such that the optical signal has a wavelength which is adapted to the grating period.

The at least one diffractive input grating supports the tracking of the optical signal which is directed as laser light via the input grating towards the sensing element. The term "adapted to the grating period" denotes that when the semiconductor laser and/or sensing element and/or input grating undergo perturbations due to changing environmental conditions, such as temperature, strain, etc., then the semiconductor adapts the optical signal to fit the grating period of the input grating. In turn, the "fitting" to the grating period may be defined in terms of a grating equation, e.g. the Bragg equation, describing the optical device.

Hence, although semiconductor laser, input grating and sensing element may be prone to different environmental conditions, such as mechanical strain or temperature, they will track each other thanks to the coupling by the common sensor package and by the wavelength selective feedback. Thus, the optical device preserves or even improves its intended laser properties under variation of external conditions. For example, the optical signal or a fraction thereof coupled out as laser light, is kept locked on a wavelength determined by the input grating. This also reduces the required accuracy at manufacturing, i.e. the laser wavelength and the sensor gratings are allowed to have some "mismatch". When put together, the optical signal, represented by laser wavelength $\lambda$, will align onto the input grating period $\Lambda$. This allows for more margin in the grating period and in the laser because, in the end, the semiconductor laser will adjust itself and cancel the mismatch, at least to some extent. The optical device is less expensive and easier to miniaturize or integrate into a photonic detector than if the manufacturer or customer had to provide means to stabilize the device thermally and mechanically.

In at least one embodiment the gain element comprises an active gain region of an edge-emitting semiconductor laser. Alternatively, the gain element comprises an active gain region of a surface-emitting semiconductor laser. These types of semiconductor laser employ a semiconductor diode junction as active gain region (or active laser medium).

In at least one embodiment, the gain element comprises a laser cavity in which the active laser medium is arranged. The laser cavity comprises a back mirror and a semi-transparent front mirror, for example. It should be noted that the laser cavity is different from the external cavity which is formed by the gain element and the wavelength selective feedback element. The lasing process, however, is largely determined by the external cavity rather than the laser cavity. For example, the semi-transparent front mirror does not affect the lasing process of the external cavity, which may be defined by the input grating as front mirror.

The term "external cavity" can be understood as external with respect to the laser cavity. For a semiconductor laser, in this document, "laser cavity" designates the optical cavity limited to the volume of the semiconductor, typically defined by the mirrors coated on its surfaces. As opposite, the "external cavity" is the optical cavity which has at least one of the mirrors (or reflectors), external with respect to the semiconductor volume. The laser cavity can be left intact, i.e. a semiconductor laser can be implemented as it is into the common sensor package. Alternatively, the semiconductor laser can be altered such that the semi-transparent front mirror is removed or replaced by an anti-reflecting coating, for example.

In at least one embodiment the optical device further comprises at least one further output grating and a substrate body. The at least one input grating and at least one further output grating are arranged in or on the substrate body, e.g. are contiguous with a main surface of the substrate body. The substrate body may have a semiconductor, such as silicon, or other material (like $SiO_2$, $Si_3N_4$, etc.), which is transparent for or in the range of a target wavelength. For example, silicon is - to a certain degree - transparent in the infrared, IR. Moreover, IR may be the target wavelength or range when using a VCSEL laser which emits in the IR. In other applications the substrate body may be transparent in other spectral ranges, such as Vis or UV. This way the substrate body may function as an optical waveguide for the optical signal or laser light.

The substrate body may include an optical waveguide at the surface of the substrate body, e.g. beneath the grating, either diffused/implanted, or deposited. This optical waveguide, characterized by its effective refractive index $n_{eff}$ may confine and transfer light between the gratings, e.g. input and first grating, respectively, between the second grating and output. The optical waveguide is optional but may help with loss reduction, and with increasing the interaction between the laser beam and the gratings.

Both the input and output grating may be arranged in the substrate body. This way their grating periods are in a constant and well-defined ratio. If any one of the gratings expands by a factor (due to temperature variation, for instance), the other gratings should expand by the same factor.

In at least one embodiment the main surface of the substrate body defines an optical axis running along a longitudinal direction of the substrate body parallel to the main surface. The at least one output grating is located downstream the at least one input grating. An input side of the input grating faces the gain element and an output side is associated with the output grating. The optical waveguide can be characterized by the optical axis and, in turn, the optical waveguide can be considered the materialization of the optical axis.

In at least one embodiment the semiconductor laser comprises a laser cavity having a laser axis which runs along a longitudinal direction of the laser cavity. The laser axis is coaxial with respect to the optical axis of the substrate body. This embodiment can be considered a Littrow-type setup with grazing incidence. The input grating acts as front mirror of the external cavity for the semiconductor laser. Variations of grating period $\Lambda$ and effective refractive index force the laser wavelength $\lambda$ to vary accordingly such that the relation **sin $\theta_d$ = 0** holds. The term $\theta_d$ denotes a diffraction angle. An extracted beam from the laser may stay perpendicular to the input grating, independently from the grating period $\Lambda$ and effective refractive index variations.

Alternatively, the laser axis is tilted with respect to the optical axis of the substrate body. This allows for implementing different types of setups, such as a Littrow or a Littman-Metcalf configuration wherein the input grating can be considered part of the external cavity. In case of a Littman-Metcalf setup the external cavity can be complemented by at least one more mirror acting as front mirror of the external cavity. This setup too forces the laser wavelength $\lambda$ to track variations of grating period $\Lambda$ and effective refractive index.

In at least one embodiment the external cavity comprises a back mirror of the semiconductor laser and the at least one input grating as a front mirror.

In at least one embodiment the external cavity comprises the back mirror of the semiconductor laser and a semi-transparent mirror as the front mirror. Furthermore, the input grating is arranged downstream the back mirror and the semi-transparent mirror. The external cavity can be implemented based on a Littman-Metcalf configuration. For example, the laser axis can be coaxial with respect to the optical axis of the substrate body. The input grating can be positioned downstream a collimating lens which is coaxial with the laser axis. One order of the input grating can be arranged to reflect the optical signal, and another order of the input grating can be arranged to transmit the optical signal. The input grating may be tilted with respect to the laser axis in order to configure the two orders for reflection and transmission. For example, a tilting angle may be 45 degrees with respect to the laser axis.

In at least one embodiment the input grating comprises at least a first section having a first grating period and a second section having a second grating period. The first section comprises the input side. The second section is located downstream of the first section along the optical axis. The first section is arranged for reflection of the optical signal back into the semiconductor laser. The second section is arranged to direct the optical signal towards the sensing element.

Due to design constrains it may not possible to implement an input grating with two or more diffractions orders with at least one for the sensing element and another for the external cavity, respectively. However, splitting the input grating into sections may provide larger freedom in designing the optical device. For example, the input grating may have sections with different periods, respectively. One section is arranged with a first period to be used for reflection back into the semiconductor laser, and a second section with a second grating period arranged to direct laser light towards the sensing element. Typically, both sections share the same substrate in order to have possible deformations under varying parameters (such as temperature or mechanical stress) correlated with each other.

In at least one embodiment a photonic detector comprises at least one of the optical devices according to the concept laid out above. Furthermore, the photonic detector comprises an integrated sensor chip which comprises at least one of an optical sensor, an optical frontend, an electrical frontend and/or a processing unit. The at least one optical device and the integrated sensor chip are arranged in the common sensor package.

The photonic detector can be implemented as a single device integrated optical solution. Besides the optical device there may be further components implemented in the same common sensor package, including an analog or digital optical front end for receiving sensor signals, an analog electrical front end for controlling operation of the photonic detector, a processing unit such as Cortex processor, a synchronous demodulator, an integrated laser driver and/or optical filters.

In at least one embodiment the photonic detector comprises a reference path and a sensing path arranged for interference of a reference beam and a sensing beam. For example, the sensing path involves the external cavity, input and output grating and sensing element. The reference path does not run through the sensing element. An output signal from the sensing path, i.e. after being deflected at the sensing element, may then be superimposed with an output signal from the reference path. Due to interference a final output can be generated which then constitutes the output of the photonic device. Processing or pre-processing of this output may already be performed on-chip, e.g. by means of the processing unit.

In at least one embodiment the photonic detector comprises at least one of an integrated optical interferometer, a differential free space optical interferometer, an optical acoustic sensor, an optical audio microphone, an optical audio speaker control device, an optical audio display surface microphone or speaker, a contactless 3D surface mapping and sensing device, a contactless photonic environment sensing device, and/or a pressure sensor.

In at least one embodiment a method of manufacturing an optical device for an optical sensor comprises the following steps. First, at least part of a wavelength selective feedback element and a sensing element are arranged in a common sensor package. A gain element is arranged with respect to the at least one wavelength selective feedback element and the sensing element such that the gain element is operable to generate and amplify an optical signal. Using the gain element and the wavelength selective feedback element at least part of an optical cavity of the semiconductor laser is formed. Thereby, a feedback mechanism is provided to sustain a laser oscillation depending on the wavelength of the optical signal. Finally, the wavelength selective feedback element is arranged to couple out a fraction of the optical signal and direct said fraction of the optical signal towards the sensing element in order to probe a physical property of the sensing element.

In at least one embodiment the gain element and the external cavity are arranged in the common sensor package.

Further implementations of the method of manufacturing an optical device for an optical sensor are readily derived from the various implementations and embodiments of the optical device and photonic detector discussed above, and vice versa.

In the following, the concept presented above is described in further detail with respect to drawings, in which examples of embodiments are presented. In the embodiments and Figures presented hereinafter, similar or identical elements may each be provided with the same reference numerals. The elements illustrated in the drawings and their size relationships among one another, however, should not be regarded as true to scale, rather individual elements, such as layers, components, and regions, may be exaggerated to enable better illustration or a better understanding.

| | |
|---|---|
| Figure 1 | shows an example embodiment of an optical device, |
| Figure 2 | shows diffraction modes of an example input grating, |
| Figure 3 | shows another example embodiment of an optical device, |
| Figure 4 | shows diffraction modes of another example input grating, and |
| Figures 5A to 5C | show cavity configurations from the prior art. |

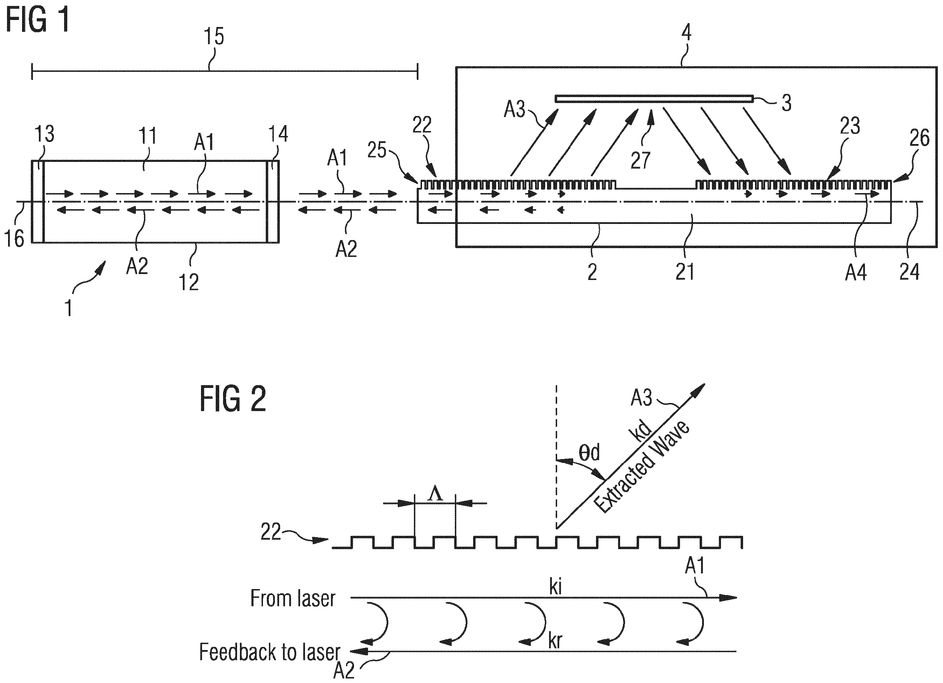

Figure 1 shows an example optical device. The optical device comprises a gain element 11 of a semiconductor laser 1, a wavelength selective feedback element 2, and a sensing element 3. The wavelength selective feedback element 2 and the sensing element 3 are arranged in a common sensor package 4. The gain element 11 can also be arranged in the common sensor package 4 (not shown) or could be an external component outside the common sensor package 4 as depicted. The common sensor package 4 is arranged to accommodate and align the components of the optical device. For example, the common sensor package 4 comprises a frame body to which at least the wavelength selective feedback element 2 and the sensing element 3 are attached to. The frame body can be molded, for example. Another example is to build the elements 2 and 3 into a common silicon substrate, this substrate thus representing the common sensor package. Furthermore, the common sensor package 4 may comprise further components of a photonic detector, such as an optical sensor, control and data processing units, which complement the optical device to a full photonic detector, for example.

Typically, the optical device can be used in various optical sensors or photonic detectors. This way the optical device finds applications in integrated optical interferometers, differential free space optical interferometers, optical acoustic sensors, optical audio microphones, optical audio speaker control, optical audio display surface microphones and speakers, contactless 3D surface mapping and sensing, contactless photonic environment sensing, pressure sensors and external cavity lasers, for example. Any sensor composed of a gain element of a semiconductor laser, a wavelength selective feedback element, such as a Bragg grating, and a sensing element may be used together with the optical device described herein. The sensing element 3 can be considered any element which transduces a physical measure, e.g. pressure, temperature, etc. into an optical path change, which may then be sensed by interference with a reference path, for example.

The gain element 11 of a semiconductor laser 1 comprises an active gain region (or active laser medium), e.g. a semiconductor diode junction. Furthermore, the gain element 11 comprises a laser cavity 12 in which the active laser medium is arranged. The laser cavity 12 in this embodiment comprises a back mirror 13 and a semi-transparent front mirror 14. Such a configuration may be implemented by means of a semiconductor laser, such as an edge-emitting semiconductor laser, a surface-emitting semiconductor laser, e.g. a vertical-cavity surface-emitting laser, or VCSEL.

The wavelength selective feedback element 2 comprises a substrate body 21. The substrate body 21 may comprise, for example, a semiconductor, such as silicon, or another material, which is transparent for, or in the range of, a target wavelength. For example, silicon is - to a certain degree - transparent in the infrared, IR. Moreover, IR may be the target wavelength or range when using a VCSEL laser which emits in the IR. Similar considerations on substrate, target wavelengths and laser emission apply for other applications as well. Infrared semiconductor laser wavelengths for sensing applications, are in the ranges 780 to 850 nm (AlGaAs) or 900 to 980 nm (InGaAs).

A first diffraction grating 22, such as a Bragg grating, is arranged in the substrate body 21. In this embodiment the substrate body 21 comprises an optical waveguide and the Bragg grating is a diffraction grating made in the optical waveguide with a periodic variation of the refractive index, e.g. of the substrate 21, or of the waveguide. This periodic variation leads to large reflectance within its bandwidth around a center wavelength which fulfills the Bragg condition for grating reflection. If the Bragg condition is met, the wavenumber of the grating matches the difference of the wavenumbers of the incident and reflected waves. In turn, other wavelengths are only weakly or not affected by the Bragg grating. Similarly, the reflection can nearly or totally disappear when the angle of incidence is modified. These properties allow for using the Bragg grating as an optical filter, for example. Furthermore, the substrate body 21 carrying the first diffraction grating can be used as, or include, a photonic waveguide and allows, thanks to the grating, for selecting wavelengths which are coupled out of or into the waveguide, respectively.

The same substrate body 21 may have a second diffraction grating 23. The second diffraction grating 23 can be a Bragg grating as well and may be spaced apart from the first diffraction grating 22. For example, the substrate body 21 has a main surface which defines an optical axis 24. The optical axis 24 runs along a longitudinal direction of the substrate body 21. Considering the optical axis 24, the second diffraction grating 23 is located downstream the first diffraction grating 22 with an input side 25 of the first diffraction grating 22 facing the gain element 11 and an output side 26 associated with the second diffraction grating 23. The gain element 11 and the substrate body 21 having the two Bragg gratings 22, 23, are arranged coaxial with respect to the common optical axis 24.

The first diffraction grating 22, or input grating for short, is designed to have at least two diffraction orders to facilitate both sensor and laser operation, respectively. At least one order of diffraction is directed towards the gain element 11, or laser cavity 12. A second diffraction order of the grating 22 is directed firstly towards the sensing element 3 (see arrow A3). Then, after reflection upon sensing element 3, and coupling into the output waveguide through the second grating 23, this beam reaches the output 26. Typically, the output side 26 faces towards an optical sensor or is part of a photonic detector, for example. Thus, the input grating 22 has a period $\Lambda$ that allows said two diffraction orders in order to transmit light towards the optical sensor or into the photonic detector, and reflect light backwards into the gain element 11 or laser cavity 12. This way the input grating 22, e.g. the Bragg grating, becomes also an external mirror for the semiconductor laser 1. In turn, the semiconductor laser 1 becomes an external cavity laser.

The second grating 23 may, functionally, not be part of the wavelength selective feedback. The second grating 23 is operable to couple the light beam incoming from the sensing element 3 into the output (waveguide). Physically, the second grating 23 can be either spaced apart, or be contiguous with the first (input) grating 22, for example.

The external cavity 15 comprises the gain element 11, or laser cavity 12, and the input grating 22. The laser cavity 12 comprises the back mirror 13, which effectively constitutes a back mirror of the external cavity 15, too. The semi-transparent front mirror 14, however, does not affect the lasing process of the external cavity 15, which rather is defined by the input grating 22 as front mirror. In fact, the front mirror 14 can be removed or replaced by an anti-reflecting coating, for example.

The sensing element 3 is arranged in the common sensor package 4, e.g. along the optical axis 24 opposite and between the input and output gratings 22, 23 (with respect to the optical axis 24). An optical path 27 is established between the input grating 22, the sensing element 3 and the output grating 23. The sensing element 3 can be any element which transduces a physical measure, e.g. pressure, temperature, etc. into a change of the optical path 27, which may then be sensed by interference with a reference path, for example. In this example, the sensing element 3 is implemented by a MEMS membrane arranged in the common sensor package 4.

The input grating 22 can be considered both the front mirror of the external cavity 15 and a sensor component to probe the sensing element. The semiconductor laser 1 constitutes an external cavity laser which is correlated in wavelength $\lambda$ with its target, the optical device composed of the sensing element 3 together the two gratings 22 and 23, and, during operation of the optical device and/or optical sensor, tracks an optimal wavelength as will be discussed below.

An input signal excites the active laser medium of the gain element 11. An optical signal, or laser light, is generated and induces stimulated emission in the external cavity 15. For example, arrows A1 in Figure 1 represent light which traverses as laser input waves towards the input grating 22. In turn, light is reflected at the input grating 22 which acts as the front mirror of the external cavity 15. In more detail, one order of diffraction of the input grating 22 is used to diffract light backwards into the external laser cavity 15. The reflected order light is indicated by arrows A2 in the drawing. After being reflected at the input grating 22, light traverses back, through the front mirror 14, until the back mirror 13. As a result a laser process and optical amplification of the optical signal is established. This way laser oscillation can be sustained. Thanks to the reflected wave, the input grating 22 becomes an external, wavelength-selective mirror for the semiconductor laser 1.

A fraction of the optical signal is not reflected back into the external cavity 15 but diffracted by means of the input grating 22 (see arrows A3). This fraction of the optical signal provides a laser output (or laser light) and is diffracted towards the sensing element 3. Another diffraction order of the input grating 22 is used to extract and direct the laser light to the sensing element 3 for sensing purposes. This diffraction order relates to the same beam denoted with arrows A3. The laser light is reflected at the sensing element and eventually deflected towards the output grating 23. Deflection is altered by the sensing element 3.

For example, a movement of the sensing element, such as the MEMS membrane discussed above, changes the length of the optical path 27. Depending on the optical path length the deflected laser light strikes the output grating 23 under a characteristic angle of incidence and may be coupled into the substrate body 21 or the output waveguide via the output grating 23 according to its grating equation (see arrows A4).

Figure 2 shows diffraction modes of an example input grating. The input grating 22, being wavelength-selective, forces the semiconductor laser 1 to lase on the wavelength reflected by the input grating. The semiconductor laser 1 is able to displace its lasing frequency thanks to the relatively large bandwidth of the gain medium of the gain element 11, a few nm usually. The sensor input side 25 from Figure 1 is detailed in Figure 2 showing the input grating 22, with period $\Lambda$, arranged in the substrate body 21 (eventually including a waveguide along its optical axis 24). The substrate (or waveguide) is characterized by an effective refractive index $n_{eff}$. Furthermore, Figure 2 shows the incident wave **ki,** and the two diffracted waves: one decoupled out of the waveguide (denoted extracted or diffracted wave **kd** or laser light), and one returned towards the laser cavity 12 (denoted reflected wave **kr),** and providing the feedback. Arrows A1 to A3 correspond to Figure 1.

The embodiment shown in Figure 1 can be considered a Littrow-type setup, in the extreme case of grazing incidence, i.e. **sin** $\theta_i$ = 1 ($\theta_i$ is the angle between the incident beam **ki** and a perpendicular to the grating surface, like in Figure 4). The laser cavity 12 has a laser axis 16 which in this setup is coaxial with the optical axis 24 of the substrate body 21.

In order for the input grating 22 to act as a reflector and couple energy from the laser input wave (see arrows A1) into the wave travelling through the same waveguide backwards via substrate body 21 (reflected wave, see arrows A2), towards the external laser cavity 15, the grating period **A** and the wavelength have to be related through the Bragg condition which in this case reads

$$\lambda = \frac{2n_{eff}\Lambda}{m}$$

with m = $\pm 1$, $\pm 2$, $\pm 3$, ... denoting the diffraction order and $\lambda$ the laser wavelength. The effective index $n_{eff}$ is defined through the propagation constant of the guided-mode $\beta_{eff} = \dfrac{2\pi n_{eff}}{\lambda}$ , wherein $n_{eff}$ has a value between the guide core and cladding refractive indexes, for example. The equation above illustrates that the semiconductor laser 1 is forced to lase on a wavelength that fulfills the Bragg condition, with m chosen such that the laser wavelength $\lambda$ falls within the (laser) gain bandwidth.

In order for the input grating 22 (implemented as Bragg grating, for example) to couple energy from the incident wave **ki** from the laser into the extracted wave **kd,** under diffraction angle $\theta_d$, as shown in Figure 2, the grating period A and the wavelength $\lambda$ additionally are related by the equation:

$$\sin \theta_d = n_{eff} - \frac{q\lambda}{\Lambda}$$

with q = $\pm 1$, $\pm 2$, $\pm 3$, ... denoting the diffraction order. If both the Bragg condition and the latter equation hold, and if one chooses m and q such that m/q=2, then

$$\sin \theta_d = 0.$$

This relation is constant or independent of any variations of grating period A and effective refractive index $n_{eff}$. In other words, if the input grating acts as front mirror of the external cavity 15 for the semiconductor laser 1, it forces the laser wavelength λ to track any variations of grating period A and effective refractive index $n_{eff}$ such that $\sin\theta_d = 0$ holds. The extracted beam, represented by extracted wave **kd,** stays perpendicular ($\theta_d$=0) to the input grating 22, independent from the variations of wavelength λ, grating period A and effective refractive index $n_{eff}$.

If to the contrary, the Bragg condition would not hold, i.e. the input grating 22 would not be part of the external cavity 15 for the semiconductor laser 1, then, depending on the laser wavelength λ variations on one side, and grating period A and effective refractive index $n_{eff}$ variations on the other, the diffraction angle $\theta_d$ would deviate from zero. Consequently, the extracted beam would deviate from its initial direction (perpendicular to the input grating). This is because the laser wavelength λ on one side, and the grating/waveguide parameters on the other, would vary in an unrelated way.

In other embodiments it may not be possible to implement an input grating with two or more diffractions orders, i.e. at least one for the sensing element and another for the external cavity as described above. However, the input grating 22 can be split into sections. For example, the input grating may have sections with different grating periods, respectively. One section is arranged with a first period to be used for reflection back into the semiconductor laser, and a second section with a second grating period arranged to direct laser light towards the sensing element. Typically, both sections share the same substrate 21 in order to have possible deformations under varying parameters (such as temperature or mechanical stress) correlated with each other. At least one section of the input grating is arranged in the common sensor package 4.

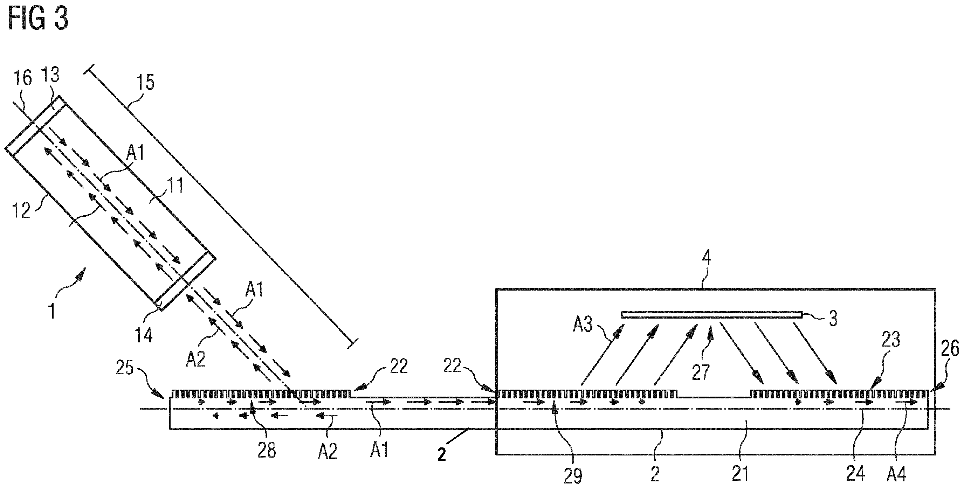

Figure 3 shows another example embodiment of an optical device. The optical device comprises a gain element 11 of a semiconductor laser 1, a wavelength selective feedback element 2, and a sensing element 3. A part of the wavelength selective feedback element 2 and the sensing element 3 are arranged in a common sensor package 4. The whole input grating 22 can also be arranged in the common sensor package 4 (not shown). The gain element 11 can also be arranged in the common sensor package 4 (not shown) or can be an external component, outside the common sensor package 4, as depicted.

The various components of the optical device are similar to their respective counterparts discussed with respect to the embodiment of Figures 1 and 2. Thus, the following discussion will focus on the differences. If not stated otherwise properties of the components discussed above with respect to Figures 1 and 2 apply equally to the embodiment of Figures 3 and 4.

In this embodiment the gain element 11, or laser cavity 12, can be the same as in Figure 1, i.e. comprises a back mirror 13 and a semi-transparent front mirror 14. However, the gain element 11, or laser cavity 12, is tilted with respect to the optical axis 24 of the substrate body 21. That is, the laser axis 16, common to the gain element 11 and laser cavity 12 of the semiconductor laser 1, is not coaxial but tilted with respect to the substrate axis 24 of the substrate body 21. The substrate body 21 has the two Bragg gratings 22, 23. The wavelength selective feedback element 2 comprises the input grating 22. The input grating 22 and the output grating 23 are arranged in the common substrate body 21, along its optical axis 24. The output grating 23 is located downstream the input grating 22 with the input side 25 facing the gain element 11, and the output side 26 associated with the output grating 23. The input grating 22 comprises two sections 28 and 29. A first section 28 of the input grating comprises the input side 25 and a second section 29 of the input grating is located downstream the first section along the optical axis 24.

The first section 28 is arranged to couple energy from the incident wave **ki** from the laser (arrows A1) partly into the guided wave propagated through the waveguide/substrate to the second section 29, and partly into the wave **kr** (arrows A2) reflected backwards, to the gain element 11. Hence the input grating 22 defines also the external cavity 15 of the semiconductor laser 1. The first section 28 of the input grating may (but does not have to) be spatially separate from the second section 29 and/or the output grating 23, and also may have a grating period different from the second section and/or the output grating. Nevertheless, all the gratings (the sections of the input grating and the output grating) are arranged in the common substrate body 21, such that their grating periods are in a constant and well-defined ratios. If any one of the gratings expands by a factor (due to temperature variation, for instance), the other gratings should expand by the same factor.

Figure 4 shows the waves and their corresponding diffraction orders of the input grating 22 in the embodiment example illustrated in figure 3. The drawing from figure 4 represents the two sections (28 and 29) of the input grating 22, with their respective periods and beam angles. The first section 28 of the input grating (on the left side of the figure) can be considered the external laser cavity for the semiconductor laser 1 by returning or reflecting, through a diffraction order, the wave represented by **kr** (arrow A2) backwards into the laser cavity 12, i.e. towards the back mirror. The incident wave **ki** from the laser strikes the first section 28 under a first incidence angle $\theta_i$ with respect to the normal to the grating surface. The wave **kr** is reflected backwards (as a diffraction order), into the laser cavity, hence under the same angle $\theta_i$ with respect to the normal to the grating surface. The laser wavelength A is hence defined by the Bragg condition on the section 28 of the grating, which reads

$$\lambda = \frac{2\,\Lambda_i \sin \theta_i}{m}$$

with m = $\pm 1$, $\pm 2$, $\pm 3$, denoting the diffraction order, $\Lambda_i$ the grating period of the first section 28, and $\lambda$ the laser wavelength. Note that this equation does not depend on $n_{eff}$. Light strikes the grating and is diffracted back into the laser from the "air" side of the grating, which thus acts like a classical, open-space, diffraction grating. If the light came through the optical waveguide the equation would be different and had $n_{eff}$ contribution.

The same section 28 of the input grating is ensuring the coupling between the input wave **ki** and the guided-wave mode **kg** of effective index $n_{eff}$ (see arrows A4). Therefore

$$\sin \theta_i = n_{eff} - \frac{q\lambda}{\Lambda_i}$$

with q = $\pm 1$, $\pm 2$, $\pm 3$, ... denoting the diffraction order.

The second section 29 of the input grating (on the right side of Figure 4) couples the guided-wave mode **kg** out, into the wave **kd** (arrow A3), towards the sensing element, at a second diffraction angle $\theta_d$ with respect to the normal. Therefore

$$\sin \theta_d = n_{eff} - \frac{p\lambda}{\Lambda_d}$$

with p = $\pm 1$, $\pm 2$, $\pm 3$, ... denoting the diffraction order. These equations express the diffraction or coupling angles $\theta_d$ and $\theta_i$ as functions of the other parameters, e.g. the laser wavelength $\lambda$, or grating periods $\Lambda_i$, $\Lambda_d$, which vary the most with the temperature. The diffraction or coupling angles $\theta_i$ and $\theta_d$ denote

- $\theta_i$: the "incident" angle formed between the normal to the surface of the first grating section 28 of the input grating 22 and the incident light wave A1 incoming from the laser. It is identical to the angle between the same perpendicular and the light wave A2 reflected (actually diffracted) by the first section 28 of the input grating backwards, towards the gain element 11.
- $\theta_d$: is the "diffraction" angle formed between the perpendicular to the surface of the second section 29 of the input grating 22 and the light wave A3 extracted (or diffracted) towards the sensing element 3 by this section 29.

Without the constraint of the input grating being equally the external cavity of the laser, the laser wavelength $\lambda$ variation (with the temperature, for example) would be independent from the gratings expansions. Consequently, extraction angle $\theta_d$ would vary with the temperature, and the light path directions inside the sensor would fluctuate, with impact on the sensor performance. However, in this embodiment the various parameters are interlinked by the Bragg condition, and the input grating is used as external cavity to the semiconductor laser. This constrains the laser wavelength $\lambda$ to adapt to the Bragg condition at the input grating 28. By combining the Bragg condition and equations for (de-)coupling angles $\theta_d$ and $\theta_i$, one obtains for the injection (coupling) and the extraction (decoupling) angles the following equations

$$\sin \theta_i = \frac{n_{eff}}{1 + 2\dfrac{q}{m}}$$

and

$$\sin \theta_d = n_{eff}\left(1 - \frac{2p}{m + 2q}\right)\frac{\Lambda_i}{\Lambda_d}$$

The last two equations show that the injection and extraction angles are constant and independent from the laser wavelength $\lambda$, and the grating periods, as the grating period variations at injection ($\Lambda_i$, grating 28) and extraction ($\Lambda_d$, grating 29) are correlated ($\Lambda_i/\Lambda_d$ = constant), and as the laser wavelength $\lambda$ is constrained to match the Bragg condition at input grating 28, corresponding to the injection angle $\theta_i$. Hence the light path directions inside the sensor stay unchanged, independent from wavelength and grating period variations (following temperature or stress fluctuations, for instance). It remains, however, a temperature dependence by way of the effective index $n_{eff}$. This temperature dependence usually has less impact on the coupling angles than temperature variations of laser wavelength in regular Fabry-Perot or VCSEL laser setups. It has been found that the proposed optical device shows improved stability under varying temperature and/or mechanical stress. Having two grating sections 28 and 29 on the input grating 22 supports a more general application, e.g. with p≠q and the incident and diffracted angles not being equal.

Reference numerals

1    semiconductor laser
2    wavelength selective feedback element
3    sensing element
4    sensor package

11     gain element
12     laser cavity
13     back mirror
14     front mirror
15     external cavity
16     laser axis
21     substrate body
22     first diffraction (input) grating
23     second diffraction (output) grating
24     optical axis
25     input side
26     output side
27     optical path
28     first section of input grating
29     second section of input grating
A1     arrow representing an incident wave
A2     arrow representing a reflected wave
A3     arrow representing a diffracted wave
A4     arrow representing a guided wave

**Claims**

1. An optical device for an optical sensor, comprising a gain element (11) of a semiconductor laser (1), a wavelength selective feedback element (2), and a sensing element (3), wherein:

   - at least part of the wavelength selective feedback element (2) and the sensing element (3) are arranged in a common sensor package (4),
   - the sensing element (3) being operable to transduce a physical measure, such as pressure or temperature, into an optical path change, and operable to probe the optical path change by interference with a reference path,
   - the gain element (11) is arranged to generate and amplify an optical signal,
   - the gain element (11) and the wavelength selective feedback element (2) form at least part of an external cavity (15) of the semiconductor laser (1), thereby providing a feedback mechanism to sustain a laser oscillation depending on the optical signal, and
   - the wavelength selective feedback element (2) is arranged to couple out a fraction of the optical signal and direct said fraction of the optical signal towards the sensing element (3) to probe a physical property of the sensing element (3).

2. The optical device according to claim 1, wherein the gain element (11) and the external cavity (15) are arranged in the common sensor package (4).

3. The optical device according to claim 1 or claim 2, wherein the gain element (11) comprises an active gain region of an edge-emitting semiconductor laser or an active gain region of a surface-emitting semiconductor laser. It

4. The optical device according to one of claims 1-3, wherein the wavelength selective feedback element (2) comprises at least one diffractive input grating (22) with a grating period $\Lambda$, wherein the external cavity (15) is arranged such that the optical signal has a wavelength adapted to the grating period $\Lambda$.

5. The optical device according to claim 4, comprising:

   - at least one further output grating (23), and
   - a substrate body (21), wherein the at least one input grating (22) and at least one further output grating (23) are arranged in or on the substrate body (21) and contiguous with a main surface of the substrate body (21).

6. The optical device according to claim 5, wherein

   - the main surface of the substrate body (21) defines an optical axis (24) running along a longitudinal direction of the substrate body (21) parallel to the main surface, and
   - the at least one output grating (23) is located downstream the at least one input grating (22) with an input side (25) of the input grating (22) facing the gain element (11) and an output side (26) associated with the output grating (23).

7. The optical device according to claim 6, wherein

   - the semiconductor laser (1) comprises a laser cavity (12) having a laser axis (16) running along a longitudinal direction of the laser cavity (12),
   - the laser axis (16) is coaxial with respect to the optical axis (24) of the substrate body (21), or
   - the laser axis (16) is tilted with respect to the optical axis (24) of the substrate body (21).

8. The optical device according to one of claims 4 to 7, wherein the external cavity (15) comprises a back mirror (13) of the semiconductor laser (1) and the at least one input grating (22) as front mirror.

9. The optical device according to one of claims 4 to 7, wherein

   - the external cavity (15) comprises the back mirror (13) of the semiconductor laser (1) and a semitransparent mirror as front mirror,
   - the input grating (22) is arranged downstream both the back mirror (13) and the semitransparent mirror.

10. The optical device according to claim 6 or according to claim 6 and one of claims 7 to 9, wherein

- the input grating comprises at least a first section (28) having a first grating period and a second section (29) having a second grating period,
- the first section (28) comprises the input side (25),
- the second section (29) is located downstream the first section (28) along the optical axis (24), and
- the first section (28) is arranged for reflection of the optical signal back into the semiconductor laser (1), and the second section is arranged to direct the optical signal towards the sensing element (3).

11. A photonic detector, comprising:

- at least one optical device according to one of claims 1 to 10, and further comprising:
- an integrated sensor chip comprising at least one of: an optical sensor, an optical front end, an electrical front end and/or a processing unit; wherein:
- the at least one optical device and the integrated sensor chip are arranged in the common sensor package (4).

12. The photonic detector according to claim 11, comprising a reference path and a sensing path arranged for interference of a reference beam and a sensing beam.

13. The photonic detector according to claim 11 or 12, wherein the photonic detector comprises one or several of:

- an integrated optical interferometer,
- a differential free space optical interferometer,
- an optical acoustic sensor,
- an optical audio microphone,
- an optical audio speaker control device,
- an optical audio display surface microphone or speaker,
- a contactless 3D surface mapping and sensing device,
- a contactless photonic environment sensing device, and/or
- a pressure sensor.

14. A method of manufacturing an optical device for an optical sensor, comprising the steps of:

- arranging at least part of a wavelength selective feedback element (2) and a sensing element (3) in a common sensor package (4), wherein the sensing element (3) is operable to transduce a physical measure, such as pressure or temperature, into an optical path change, and operable to probe the optical path change by interference with a reference path,
- arranging a gain element (11) with respect to the wavelength selective feedback element (2) and the sensing element (3) such that the gain element is operable to generate and amplify an optical signal,
- forming at least part of an external cavity of a semiconductor laser using the gain element and the wavelength selective feedback element (2), thereby providing a feedback mechanism to sustain a laser oscillation depending on the optical signal, and
- arranging the wavelength selective feedback element (2) to couple out a fraction of the optical signal and directing said fraction of the optical signal towards the sensing element to probe a physical property of the sensing element.

15. The method according to claim 14, wherein the gain element (11) and the external cavity (15) are arranged in the common sensor package (4).

**Patentansprüche**

1. Optische Vorrichtung für einen optischen Sensor, umfassend ein Verstärkungselement (11) eines Halbleiterlasers (1), ein wellenlängenselektives Rückkopplungselement (2) und ein Sensorelement (3), wobei:

- zumindest ein Teil des wellenlängenselektiven Rückkopplungselements (2) und des Sensorelements (3) in einem gemeinsamen Sensorgehäuse (4) angeordnet sind,
- das Sensorelement (3) so betreibbar ist, dass es eine physikalische Messgröße, wie z.B. Druck oder Temperatur, in eine Änderung des optischen Wegs umwandelt, und so betreibbar ist, dass es die Änderung des optischen Wegs durch Interferenz mit einem Referenzweg prüft,
- das Verstärkungselement (11) angeordnet ist, um ein optisches Signal zu erzeugen und zu verstärken,
- das Verstärkungselement (11) und das wellenlängenselektive Rückkopplungselement (2) zumindest einen Teil eines externen Resonanzraums (15) des Halbleiterlasers (1) bilden, wodurch ein Rückkopplungsmechanismus zur Aufrechterhaltung einer Laseroszillation in Abhängigkeit von dem optischen Signal bereitgestellt wird, und
- das wellenlängenselektive Rückkopplungselement (2) so angeordnet ist, dass es einen Teil des optischen Signals auskoppelt und diesen Teil des optischen Signals auf das Sensorelement (3) richtet, um eine physikalische Eigenschaft des Sensorelements (3) zu untersuchen.

**2.** Optische Vorrichtung nach Anspruch 1, bei der das Verstärkungselement (11) und der externe Resonanzraum (15) in einem gemeinsamen Sensorgehäuse (4) angeordnet sind.

**3.** Optische Vorrichtung nach Anspruch 1 oder Anspruch 2, wobei das Verstärkungselement (11) einen aktiven Verstärkungsbereich eines kantenemittierenden Halbleiterlasers oder einen aktiven Verstärkungsbereich eines oberflächenemittierenden Halbleiterlasers umfasst.

**4.** Optische Vorrichtung nach einem der Ansprüche 1 bis 3, wobei das wellenlängenselektive Rückkopplungselement (2) mindestens ein diffraktives Eingangsgitter (22) mit einer Gitterperiode A umfasst, wobei der externe Resonanzraum (15) so angeordnet ist, dass das optische Signal eine an die Gitterperiode $\Lambda$ angepasste Wellenlänge aufweist.

**5.** Optische Vorrichtung nach Anspruch 4, umfassend:

- mindestens ein weiteres Ausgangsgitter (23), und
- einen Substratkörper (21), wobei das mindestens eine Eingangsgitter (22) und das mindestens eine weitere Ausgangsgitter (23) in oder auf dem Substratkörper (21) angeordnet sind und an eine Hauptfläche des Substratkörpers (21) angrenzen.

**6.** Optische Vorrichtung nach Anspruch 5, wobei

- die Hauptfläche des Substratkörpers (21) eine optische Achse (24) definiert, die entlang einer Längsrichtung des Substratkörpers (21) parallel zur Hauptfläche verläuft, und
- das mindestens eine Ausgangsgitter (23) hinter dem mindestens einen Eingangsgitter (22) angeordnet ist, wobei eine Eingangsseite (25) des Eingangsgitters (22) dem Verstärkungselement (11) zugewandt ist und eine Ausgangsseite (26) mit dem Ausgangsgitter (23) gekoppelt ist.

**7.** Optische Vorrichtung nach Anspruch 6, wobei

- der Halbleiterlaser (1) einen Laserresonanzraum (12) mit einer Laserachse (16) aufweist, die entlang einer Längsrichtung des Laserresonanzraums (12) verläuft,
- die Laserachse (16) koaxial zur optischen Achse (24) des Substratkörpers (21) ist, oder
- die Laserachse (16) in Bezug auf die optische Achse (24) des Substratkörpers (21) geneigt ist.

**8.** Optische Vorrichtung nach einem der Ansprüche 4 bis 7, wobei der externe Resonanzraum (15) einen Rückspiegel (13) des Halbleiterlasers (1) und das mindestens eine Eingangsgitter (22) als Frontspiegel umfasst.

**9.** Optische Vorrichtung nach einem der Ansprüche 4 bis 7, wobei

- der externe Resonanzraum (15) den Rückspiegel (13) des Halbleiterlasers (1) und einen semitransparenten Spiegel als Frontspiegel umfasst,
- das Eingangsgitter (22) sowohl hinter dem Rückspiegel (13) als auch hinter dem semitransparenten Spiegel angeordnet ist.

**10.** Optische Vorrichtung nach Anspruch 6 oder nach Anspruch 6 und einem der Ansprüche 7 bis 9, wobei

- das Eingangsgitter mindestens einen ersten Abschnitt (28) mit einer ersten Gitterperiode und einen zweiten Abschnitt (29) mit einer zweiten Gitterperiode aufweist,
- der erste Abschnitt (28) die Eingangsseite (25) umfasst,
- der zweite Abschnitt (29) hinter dem ersten Abschnitt (28) entlang der optischen Achse (24) angeordnet ist, und
- der erste Abschnitt (28) so angeordnet ist, dass er das optische Signal zurück in den Halbleiterlaser (1) reflektiert, und der zweite Abschnitt so angeordnet ist, dass er das optische Signal auf das Sensorelement (3) richtet.

**11.** Photonischer Detektor, umfassend:

- mindestens eine optische Vorrichtung nach einem der Ansprüche 1 bis 10, und ferner umfassend:
- einen integrierten Sensorchip, der mindestens eines der folgenden Elemente umfasst: einen optischen Sensor, ein optisches Frontend, ein elektrisches Frontend und/oder eine Verarbeitungseinheit; wobei:
- die mindestens eine optische Vorrichtung und der integrierte Sensorchip in dem gemeinsamen Sensorgehäuse (4) angeordnet sind.

**12.** Photonischer Detektor nach Anspruch 11, umfassend einen Referenzweg und einen Messweg, die zur Interferenz eines Referenzstrahls und eines Messstrahls ausgelegt sind.

**13.** Photonischer Detektor nach Anspruch 11 oder 12, wobei der photonische Detektor eines oder mehrere der folgenden Elemente umfasst:

- ein integriertes optisches Interferometer,
- ein differentielles optisches Freirauminterferometer,
- einen optischen akustischen Sensor,
- ein optisches Audiomikrofon,
- ein optisches Audio-Lautsprecher-Steuergerät,
- ein optisches Audio-Display-Oberflächenmikrofon oder - Lautsprecher,
- eine berührungslose 3D-Oberflächenabbildungs- und - erfassungsvorrichtung,
- eine berührungslose photonische Umgebungssensorvorrichtung, und/oder
- einen Drucksensor.

14. Verfahren zur Herstellung einer optischen Vorrichtung für einen optischen Sensor, das die folgenden Schritte umfasst:

- Anordnen mindestens eines Teils eines wellenlängenselektiven Rückkopplungselements (2) und eines Sensorelements (3) in einem gemeinsamen Sensorgehäuse (4), wobei das Sensorelement (3) so betreibbar ist, dass es eine physikalische Messung, wie z.B. Druck oder Temperatur, in eine Änderung des optischen Wegs umwandelt, und so betreibbar ist, dass es die Änderung des optischen Wegs durch Interferenz mit einem Referenzweg prüft,
- Anordnen eines Verstärkungselements (11) in Bezug auf das wellenlängenselektive Rückkopplungselement (2) und das Sensorelement (3), so dass das Verstärkungselement betreibbar ist, um ein optisches Signal zu erzeugen und zu verstärken,
- Bilden mindestens eines Teils eines externen Resonanzraums eines Halbleiterlasers unter Verwendung des Verstärkungselements und des wellenlängenselektiven Rückkopplungselements (2), wodurch ein Rückkopplungsmechanismus zum Aufrechterhalten einer Laseroszillation in Abhängigkeit von dem optischen Signal bereitgestellt wird, und
- Anordnen des wellenlängenselektiven Rückkopplungselements (2), um einen Teil des optischen Signals auszukoppeln, und Richten dieses Teils des optischen Signals auf das Sensorelement, um eine physikalische Eigenschaft des Sensorelements zu prüfen.

15. Verfahren nach Anspruch 14, wobei das Verstärkungselement (11) und der äußere Resonanzraum (15) in einem gemeinsamen Sensorgehäuse (4) angeordnet sind.

**Revendications**

1. Un dispositif optique pour un capteur optique, comprenant un élément de gain (11) d'un laser semi-conducteur (1), un élément de rétroaction sélective en longueur d'onde (2), et un élément de détection (3), dans lequel :

- au moins une partie de l'élément de rétroaction sélective en longueur d'onde (2) et de l'élément de détection (3) sont disposés dans un boîtier de capteur commun (4),
- l'élément de détection (3) est capable de transduire une mesure physique, telle que la pression ou la température, en une modification du trajet optique, et de sonder la modification du trajet optique par interférence avec un trajet de référence,
- l'élément de gain (11) est conçu pour générer et amplifier un signal optique,
- l'élément de gain (11) et l'élément de rétroaction sélective en longueur d'onde (2) forment au moins une partie d'une cavité externe (15) du laser à semi-conducteur (1), fournissant ainsi un mécanisme de rétroaction pour maintenir une oscillation laser en fonction du signal optique, et
- l'élément de rétroaction sélective en longueur d'onde (2) est conçu pour coupler une fraction du signal optique et diriger cette fraction du signal optique vers l'élément de détection (3) afin de sonder une propriété physique de l'élément de détection (3).

2. Le dispositif optique selon la revendication 1, dans lequel l'élément de gain (11) et la cavité externe (15) sont disposés dans l'ensemble de capteurs commun (4).

3. Le dispositif optique selon la revendication 1 ou 2, dans lequel l'élément de gain (11) comprend une région de gain actif d'un laser à semi-conducteur à émission par la tranche ou une région de gain actif d'un laser à semi-conducteur à émission par la surface.

4. Le dispositif optique selon l'une des revendications 1 à 3, dans lequel l'élément de rétroaction sélective en longueur d'onde (2) comprend au moins un réseau d'entrée diffractif (22) avec une période de réseau $\Lambda$, dans lequel la cavité externe (15) est disposée de manière à ce que le signal optique ait une longueur d'onde adaptée à la période de réseau $\Lambda$.

5. Le dispositif optique selon la revendication 4, comprenant:

- au moins un autre réseau de sortie (23), et
- un corps de substrat (21), dans lequel au moins un réseau d'entrée (22) et au moins un autre réseau de sortie (23) sont disposés dans ou sur le corps de substrat (21) et contigus à une surface principale du corps de substrat (21).

**6.** Le dispositif optique selon la revendication 5, dans lequel

- la surface principale du corps de substrat (21) définit un axe optique (24) s'étendant le long d'une direction longitudinale du corps de substrat (21) parallèle à la surface principale, et
- le au moins un réseau de sortie (23) est situé en aval du au moins un réseau d'entrée (22) avec un côté d'entrée (25) du réseau d'entrée (22) faisant face à l'élément de gain et un côté de sortie (26) associé au réseau de sortie (23).

**7.** Le dispositif optique selon la revendication 6, dans lequel

- le laser à semi-conducteur (1) comprend une cavité laser (12) ayant un axe laser (16) s'étendant le long d'une direction longitudinale de la cavité laser (12),
- l'axe laser (16) est coaxial par rapport à l'axe optique (24) du corps du substrat (21), ou
- l'axe laser (16) est incliné par rapport à l'axe optique (24) du corps du substrat (21).

**8.** Le dispositif optique selon l'une des revendications 4 à 7, dans lequel la cavité externe (15) comprend un miroir arrière (13) du laser à semi-conducteur (1) et au moins un réseau d'entrée (22) comme miroir avant.

**9.** Le dispositif optique selon l'une des revendications 4 à 7, dans lequel

- la cavité externe (15) comprend le miroir arrière (13) du laser à semi-conducteur (1) et un miroir semi-transparent comme miroir avant,
- le réseau d'entrée (22) est disposé en aval du miroir arrière (13) et du miroir semi-transparent.

**10.** Le dispositif optique selon la revendication 6 ou selon la revendication 6 et l'une des revendications 7 à 9, dans lequel

- le réseau d'entrée comprend au moins une première section (28) ayant une première période de réseau et une deuxième section (29) ayant une deuxième période de réseau,
- la première section (28) comprend le côté d'entrée (25),
- la deuxième section (29) est située en aval de la première section (28) le long de l'axe optique (24), et
- la première section (28) est conçue pour réfléchir le signal optique vers le laser à semi-conducteur (1), et la seconde section est conçue pour diriger le signal optique vers l'élément de détection (3).

**11.** Un détecteur photonique comprenant

- au moins un dispositif optique selon l'une des revendications 1 à 10, et comprenant en outre:
- une puce de capteur intégrée comprenant au moins l'un des éléments suivants : un capteur optique, un front-end optique, un front-end électrique et/ou une unité de traitement; dans lequel:
- l'au moins un dispositif optique et la puce de capteur intégrée sont disposés dans le boîtier de capteur commun (4).

**12.** Le détecteur photonique selon la revendication 11, comprenant un chemin de référence et un chemin de détection disposés pour l'interférence d'un faisceau de référence et d'un faisceau de détection.

**13.** Le détecteur photonique selon la revendication 11 ou 12, dans lequel le détecteur photonique comprend un ou plusieurs des éléments suivants :

- un interféromètre optique intégré,
- un interféromètre optique différentiel en espace libre,
- un capteur optique acoustique,
- un microphone audio optique,
- un dispositif de commande de haut-parleur audio optique,
- un microphone ou un haut-parleur de surface d'affichage audio optique,
- un dispositif de cartographie et de détection de surface 3D sans contact,
- un dispositif de détection de l'environnement photonique sans contact, et/ou
- un capteur de pression.

**14.** Une méthode de fabrication d'un dispositif optique pour un capteur optique, comprenant les étapes suivantes :

- disposer au moins une partie d'un élément de rétroaction sélective en longueur d'onde (2) et d'un élément de détection (3) dans un boîtier de capteur commun (4), dans lequel l'élément de détection (3) est capable de transduire une mesure physique, telle que la pression ou la température, en un changement de chemin optique, et capable de sonder le changement de chemin optique par l'intermédiaire d'une interférence avec un chemin de référence,
- disposer un élément de gain (11) par rapport à l'élément de rétroaction sélective en longueur d'onde (2) et à l'élément de détection (3) de manière à ce que l'élément de gain puisse générer et amplifier un signal optique,
- former au moins une partie de la cavité externe d'un laser à semi-conducteur à l'aide de l'élément de gain et de l'élément de rétroaction sélective en longueur d'onde (2), fournissant ainsi un mécanisme de rétroaction pour maintenir une oscillation laser en fonction du signal optique, et

- disposer l'élément de rétroaction sélective en longueur d'onde (2) de manière à coupler une fraction du signal optique et à diriger cette fraction du signal optique vers l'élément sensible afin de sonder une propriété physique de l'élément sensible.

**15.** La méthode selon la revendication 14, dans laquelle l'élément de gain (11) et la cavité externe (15) sont disposés dans l'ensemble capteur commun (4).

FIG 1

FIG 2

EP 3 799 231 B1

# FIG 3

EP 3 799 231 B1

# FIG 4

# FIG 5A

# FIG 5B

# FIG 5C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040258109 A1

- US 7355720 B1

**Non-patent literature cited in the description**

- **DEGERTEKIN, F. L. et al.** Fabrication and Characterization of a Micromachined Acoustic Sensor With Integrated Optical Readout. *IEEE Journal of Selected Topics in Quantum Electronics,* May 2004, vol. 10 (3